# EUROPEAN PATENT APPLICATION

(11) **EP 3 738 767 A1**
(43) Date of publication of application: **18.11.2020**
(21) Application number: 18902293.2
(22) Date of filing: 02.04.2018
(51) Int. Cl.: B32B 17/06, B32B 7/10, B32B 1/00, B32B 37/10, B32B 38/00, C03C 27/12

(54) **LAMINATED CURVED GLASS COMPOSITE MATERIAL AND MANUFACTURING METHOD THEREFOR**

(30) Priority: 25.01.2018 CN 201810075498
(71) Applicant: Changzhou Almaden Co., Ltd., Changzhou, Jiangsu 213000 (CN)
(72) Inventor: LIN, Jinhan, Changzhou, Jiangsu 213000 (CN); LIN, Jinxi, Changzhou, Jiangsu 213000 (CN)
(74) Representative: Zaboliene, Reda
(86) International application number: PCT/CN2018/081605
(87) International publication number: WO 2019/144501

(57) **Abstract**

The present invention provides a composite material of laminated curved glass and a manufacturing method thereof, the composite material of laminated curved glass includes a first glass plate, a prefabricated part, and an adhesive film configured between the first glass plate and the prefabricated part, the thickness of the first glass plate is 0.1 mm to 2.2 mm. The manufacturing method of the composite material of laminated curved glass includes processing the first glass plate with strengthening treatment, providing the adhesive film, laminating the first glass plate processed by the strengthening treatment, the adhesive film, and the prefabricated part in sequence, and then performing a low temperature press molding process to obtain the composite material of laminated curved glass. The method of the present bents the glass without high temperature to soften the glass.

## Description

### TECHNICAL FIELD

The present application relates to the technical field of glass, and particularly to a composite material of laminated curved glass and a manufacturing method thereof.

### BACKGROUND

High light transmittance and excellent physical and chemical stability of glass determine its irreplaceable and important position in the fields of construction, vehicles, new energy etc.. Toughening and lamination are common glass processing techniques that increase the safety of glass (such as wind load resistance, fall protection, bulletproof, etc.). In some special cases, in order to achieve special design goals, some double curved toughened and laminated glass products, such as the windshield of automobiles, are indispensable. The prior technology, such as a patent with the publication number CN105960384A, usually obtain a laminated curved glass by following steps: heating an ordinary flat glass to the glass softening temperature, then obtaining a curved glass by gravity molding or pressure molding, and then laminating the curved glass and an adhesive film, heating the adhesive film to a temperature that the adhesive film can be softened for gluing, thereby obtaining the laminated curved glass.

Because the above curved glass is formed at the glass softening temperature, so the glass needs to be heated to about 700 degrees, this process takes a long time, and the energy consumption is high. At the same time, when gluing the curved glass, the pressure device contacts the glass surface just with some points, it is easy to cause uneven stress on the surface of the laminated curved glass, which may finally cause some defects, such as uneven mechanical properties, uneven glue strength, and regional optical distortion.

### SUMMARY

This invention is to provide a manufacturing method for laminated curved glass thus to overcome the above-mentioned problems in the prior technology.

A composite material of laminated curved glass, wherein the composite material of laminated curved glass includes a first glass plate, a prefabricated part, and an adhesive film configured between the first glass plate and the prefabricated part, the thickness of the first glass plate is 0.1 mm to 2.2 mm.

Further, the prefabricated part is made of at least one of glass, ceramics, and metal.

A manufacturing method of the composite material of laminated curved glass includes the following steps:
(1) Providing the flat first glass plate with a thickness of 0.1 mm to 2.2 mm and providing the prefabricated part;
(2) Impose the first glass plate with strengthening treatment, the processed first glass plate is in the shape of a flat plate, and the surface stress of the first glass plate is 10-1000MPa;
(3) Low temperature molding process, adhesive film prepared, laminating the first glass plate processed in step (2), the adhesive film, and the prefabricated part in sequence, and then performing the low temperature press molding process to obtain the composite material of laminated curved glass.

Further, the prefabricated part is made of glass, and the prefabricated part is processed with the strengthening treatment of the step (2), the processed prefabricated part is in the shape of a flat plate, and the surface stress of the prefabricated part is 10-1000MPa.

Further, after the first glass plate and the prefabricated part has been processed in the step (2), the surface stress of the first glass plate or the prefabricated part is 20-900 MPa, and the flatness of the first glass plate or the prefabricated part is less than 5‰.

Further, the step (3) is performed under vacuum conditions, the degree of vacuum ≤ 50Pa.

Further, the laminated curved glass is a double curved glass.

Further, the low temperature molding process is performed in a cold pressing device, the cold pressing device includes a first mold for molding the first glass plate into a curved shape and a second mold for pressing the prefabricated part, the heating temperature of the first mold or the second mold is 80 °C to 380 °C.

Further, the first glass plate is pressed by the first mold so that the first glass plate is attached to the concave surface of the first mold, and the prefabricated part is pressed by the second mold so that the prefabricated part is attached to the convex surface of the second mold.

Further, the pressure applied by the first mold to the first glass plate or the second mold to the prefabricated part is 10-100 kPa.

Further, the prefabricated part is curved.

The beneficial effects of the present invention are as follows: the present invention provides a manufacturing method for a composite material of laminated curved glass, the first glass plate and the prefabricated part are pressed and molded to obtain the composite material of laminated curved glass under low temperature, the composite material of laminated curved glass has advantages of high strength, no bubbles, good glue strength, low energy consumption and high processing efficiency.

### BRIEF DESCRIPTION OF THE DRAWINGS

The present invention will be further described with reference to the drawings and the cases.
Fig. 1 is a schematic view of a laminated curved glass of the present invention;
Fig. 2 is a cross-sectional view along line A-A of the laminated curved glass shown in FIG. 1; and
Fig. 3 is a schematic view of the press molding process of the laminated curved glass shown in FIG. 1.

In the Figs.: 10-laminated curved glass, 11-first glass plate, 12-second glass plate, prefabricated part or bus roof prefabricated part, 13-adhesive film, 20-cold pressing device, 21-first mold, 22-second mold.

### DETAILED DESCRIPTION OF PREFERRED CASES

The present invention will now be described in detail with reference to the drawings. This figures are simplified schematic views and only illustrate the basic structure of the present invention in a schematic way, so they only show the configuration related to the present invention.

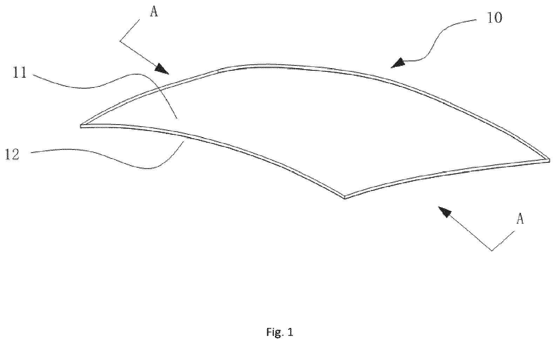

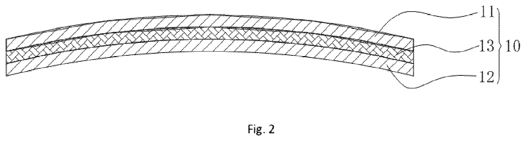

Referring to Figs. 1 and 2, the present invention provides a laminated curved glass 10. The laminated curved glass 10 includes a first glass plate 11, a second glass plate 12, and an adhesive film 13 configured between the first glass plate 11 and the second glass plate 12, and the thickness of the first glass plate 11 or the second glass plate 12 is 0.1 mm to 2.2 mm.

The first glass plate 11 or the second glass plate 12 may be float glass. Preferably, the first glass plate 11 or the second glass plate 12 is float glass with a thickness of 1.6 mm, and the ultra-white float glass contains 70.0-73% SiO₂ and 12.0-15.0% Na₂O.

The material of the adhesive film is PVB (Poly Vinyl Butyral), SGP (Ethylen/Methacrylic Acid Copolymers), POE (polyolefin elastomer) or PO (polyolefin) and other hot melt adhesive materials.

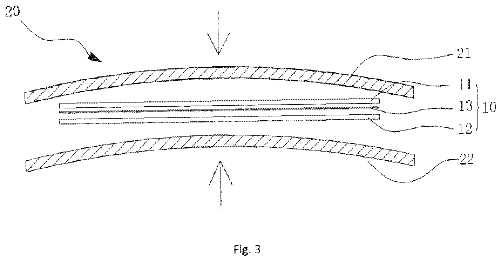

Please refer to FIG. 3 meanwhile, the manufacturing process of the laminated curved glass 10 shown in FIG. 1 includes the following steps:
(1) Providing the first glass plate 11 and the second glass plate 12 with a thickness of 0. 1 mm to 2.2 mm, and the first glass plate 11 and the second glass plate 12 are flat sheet glasses;
(2) The first glass plate 11 of step (1) and the second glass plate 12 of step (1) are processed with strengthening treatment, in this case, a flat plate strengthening treatment is processed, it can minimize damage or uneven heating of the glass caused by the contact of the glass with the transmission device or the heating device.The first glass plate 11 and the second glass plate 12 are strengthened in the shape of a flat plate. After the treatment, the first glass plate 11 or the second glass plate 12 is still in the shape of a flat plate. The surface stress of the first glass plate 11 or the second glass plate 12 is controlled within the range of 10-1000MPa, and the flatness of the first glass plate 11 or the second glass plate 12 is less than 5‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. Under conditions of vacuum pressure, the first mold 21 or the second mold 22 is heated to 80 °C to 380°C, then the adhesive film 13 is melted, and then the first glass plate 11 and the second glass plate 12 are pressed respectively by the first mold 21 and the second mold 22 at a pressure of 10KPa-100KPa, so that the first glass plate 11 is gradually attached to the concave surface of the first mold 21, and the second glass plate 12 is gradually attached to the convex surface of the second mold 22, and maintain this state for 600s to 2400s, the laminated curved glass 10 is finally manufactured.

It can be understood that the above step (I) may further include cutting the first glass plate 11 and the second glass plate 12 to the desired size, and some other processes such as edging and cleaning.

It can be understood that the first mold 21 and the second mold 22 may be heated at the same time or separately, as long as the adhesive film 13 can be softened.

The strengthening treatment in the above step (2) may be physical strengthening, that is, by heating the first glass plate 11 and the second glass plate 12 to the glass softening temperature, and maintaining for a while, and then cooling. It can be understood that the first glass plate 11 and the second glass plate 12 may also be chemical strengthening, and the chemical strengthening treatment may be a high temperature ion exchange method or a low temperature ion exchange method. For example, for the high temperature ion exchange method, during a temperature range between the softening point and the transition point of the glass, the glass containing Na₂O is immersed into a molten salt containing lithium, then Na⁺ in the glass is exchanged with Li⁺ in the molten salt, which has a smaller radius, and then cooled to room temperature. Because the expansion coefficient of the surface layer of the glass containing Li⁺ is different from the inner layer of glass containing Na⁺ or K⁺, the residual pressure on the glass surface strengthens the glass and increases its strength.

For the low temperature ion exchange method, during a temperature range not higher than the glass transition point, the glass is immersed in a molten salt containing an alkali ion having a larger radius than the alkali ions in the glass. For example, replace Na+ with K+ and then cool. A surface compressive stress layer is formed due to the volume difference of the alkali ions, which increases the strength of the glass. Although the exchange rate is slower than the high temperature ion exchange method, it has practical value because the glass is not deformed during tempering.

This case uses the low temperature ion exchange method. The first glass plate 11 and the second glass plate 12 are heated for 1 h ∼ 3 h, and the temperature thereof is raised to 300°C to 450°C. After heating to the desired temperature, the first glass plate 11 and the second glass plate 12 are placed in a potassium nitrate solution or a mixed solution of potassium nitrate and sodium nitrate, the temperature of the solution is 400°C to 450°C, and maintain for 240 min to 600 min, and then let it cool to 5°C ∼ 50°C.

The composition of the molten salt solution can be adjusted according to the composition of the glass.
(1) Providing the first glass plate 11 and the second glass plate 12 with a thickness of 1.6 mm. The first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 or the second glass plate 12 is 75MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 540s to a vacuum pressure of 30Pa, the first mold 21 is not heated, the second mold 22 is heated to 120°C, then the adhesive film 13 is melted, and then the first glass plate 11 and the second glass plate 12 are pressed respectively by the first mold 21 and the second mold 22 to a pressure of 90KPa, so that the first glass plate 11 is gradually attached to the concave surface of the first mold 21, and the second glass plate 12 is gradually attached to the convex surface of the second mold 22, and maintain this state for 1200s, the laminated curved glass 10 is finally manufactured. During the pressing process, vacuuming is continued, and bubbles in the melted adhesive film 13 are gradually discharged, and finally the laminated curved glass 10 is obtained.

### Case 2

(1) Providing the first glass plate 11 with a thickness of 1.6 mm and the second glass plate 12 with a thickness of 0.85 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 is 75MPa and that of the second glass plate 12 is 650MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 300s to a vacuum pressure of 50Pa, the first mold 21 is not heated, the second mold 22 is heated to 100°C, then the adhesive film 13 is melted, and then the first glass plate 11 and the second glass plate 12 are pressed respectively by the first mold 21 and the second mold 22 to a pressure of 80KPa, so that the first glass plate 11 is gradually attached to the concave surface of the first mold 21, and the second glass plate 12 is gradually attached to the convex surface of the second mold 22, and maintain this state for 1000s, the laminated curved glass 10 is finally manufactured. During the pressing process, vacuuming is continued, and bubbles in the melted adhesive film 13 are gradually discharged, and finally the laminated curved glass 10 is obtained.

### Case 3

(1) Providing the first glass plate 11 and the second glass plate 12 with a thickness of 2.2 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 and the second glass plate 12 is 20MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 720s to a vacuum pressure of 40Pa, the first mold 21 is not heated, the second mold 22 is heated to 180°C, then the adhesive film 13 is melted, and then the first glass plate 11 and the second glass plate 12 are pressed respectively by the first mold 21 and the second mold 22 to a pressure of 100KPa, so that the first glass plate 11 is gradually attached to the concave surface of the first mold 21, and the second glass plate 12 is gradually attached to the convex surface of the second mold 22, and maintain this state for 2400s, the laminated curved glass 10 is finally manufactured. During the pressing process, vacuuming is continued, and bubbles in the melted adhesive film 13 are gradually discharged, and finally the laminated curved glass 10 is obtained.

### Case 4

(1) Providing the first glass plate 11 with a thickness of 1.3 mm and the second glass plate 12 with a thickness of 0.7 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 is 550MPa and that of the second glass plate 12 is 750MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 420s to a vacuum pressure of 40Pa, the first mold 21 is not heated, the second mold 22 is heated to 100°C, then the adhesive film 13 is melted, and then the first glass plate 11 and the second glass plate 12 are pressed respectively by the first mold 21 and the second mold 22 to a pressure of 60KPa, so that the first glass plate 11 is gradually attached to the concave surface of the first mold 21, and the second glass plate 12 is gradually attached to the convex surface of the second mold 22, and maintain this state for 800s, the laminated curved glass 10 is finally manufactured. During the pressing process, vacuuming is continued, and bubbles in the melted adhesive film 13 are gradually discharged, and finally the laminated curved glass 10 is obtained.

### Case 5

(1) Providing the first glass plate 11 with a thickness of 2.2 mm and the second glass plate 12 with a thickness of 0.1 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 is 20MPa and that of the second glass plate 12 is 900MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 420s to a vacuum pressure of 50Pa, the first mold 21 is heated to 80°C, the second mold 22 is heated to 80°C, then the adhesive film 13 is melted, and then the first glass plate 11 and the second glass plate 12 are pressed respectively by the first mold 21 and the second mold 22 to a pressure of 10KPa, so that the first glass plate 11 is gradually attached to the concave surface of the first mold 21, and the second glass plate 12 is gradually attached to the convex surface of the second mold 22, and maintain this state for 600s, the laminated curved glass 10 is finally manufactured. During the pressing process, vacuuming is continued, and bubbles in the melted adhesive film 13 are gradually discharged, and finally the laminated curved glass 10 is obtained.

### Comparative case

(1) Providing the first glass plate 11 and the second glass plate 12 with a thickness of 1.6 mm, the first glass plate 11 and the second glass plate 12 are flat sheet glasses, and the sheet glasses are float glasses. The first glass plate 11 and the second glass plate 12 are cut to the desired size, and processed by edging, cleaning, etc. In this step, the thickness and size of the first glass plate 11 and the second glass plate 12 as well as the edging, cleaning, etc. are the same as those in the first case.
(2) Pre-pressing process: the first glass plate 11 processed in step (1), the adhesive film 13 and the second glass plate 12 processed in step (1) are laminated in sequence to form a laminate, and then the laminate is placed in a vacuum bag made of rubber, and be kept at 60°C for 30 minutes and then at 100°C for 60 minutes.
(3) The pre-pressed laminate is placed in an autoclave, and heated at 140°C and 1.3 MPa for 30 minutes, and finally the laminated curved glass 10 is obtained.

In order to evaluate the performance of the laminated curved glass 10 of the cases 1-5 and the comparative case of the present invention, tests are conducted.

Stress test: Perform stress test on the sample by a surface stress meter. Let the light propagate along the glass surface, and measure the stress on the surface of the sample and the depth of the stress layer according to the photoelastic technology. Take more than five test points for each sample.

Transmittance test: Test the transmittance of the sample by a spectrophotometer, and the test wavelength range is 380nm to 1100nm.

Bending depth test: Scan the sample to test the bending depth by a three-dimensional scanner.

Gluing performance test: Detect whether the sample has bubbles or bad gluing area by AOI automatic optical detector.

### Test Results:

| Samples | Case 1 | Case 2 | Case 3 | Case 4 | Case 5 | Comparative case |
|---|---|---|---|---|---|---|
| Stress value | 75MPa | 750MPa | 20MPa | 7500MPa | 950MPa | 10MPa or less |
| Transmittance | 85.39% | 85.83% | 85.07% | 85.87% | 86.11% | 85.19% |
| Gluing performance | No bubbles, good gluing | No bubbles. good gluing | No bubbles, good gluing | No bubbles, good gluing | No bubbles, good gluing | No bubbles, good gluing |
| Penetration resistance | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample |
| Human head model simulation test | A 10kg human head model impacts the center | A 10kg human head model impacts the center | A 10kg human head model impacts the | A 10kg human head model impacts the center | A 10kg human head model impacts the | A 10kg human head model impacts the center point of the |
| | point of the sample at a height of 1.5 meters, the sample is destroyed, the human head model does not penetrate the sample, and no fragments peels off | point of the sample at a height of 1.5 meters, the sample is destroyed, the human head model does not penetrate the sample, and a small amount of small fragments peels off | center point of the sample at a height of 1.5 meters, the sample is destroyed, the human head model does not penetrate the sample, and no fragments peels off | point of the sample at a height of 1.5 meters, the sample is destroyed, the human head model does not penetrate the sample, and no fragments peels off | center point of the sample at a height of 1.5 meters, the sample is destroyed, the human head model does not penetrate the sample, and no fragments peels off | sample at a height of 1.5 meters, the sample is destroyed, the human head model does not penetrate the sample, and no fragments peels off |
| Energy consumption test | 70 seconds under high temperture | 45 seconds under high temperture | 85 seconds under high temperture | 75 seconds under high temperture | 40 seconds under high temperture | 600 seconds under high temperture |

From the above test results, it can be seen that the laminated curved glass prepared by the present invention has achieved excellent test results such as stress value, transmittance, gluing performance, penetration resistance, bending depth, and human head simulation test. The test results can meet the requirements of the automotive field. Compared with the comparative case, the cases 1-5 of the present invention have obvious advantages in stress value, and may greatly reduce the energy consumption, save the processing time, and improve the production efficiency.

In addition, in the cases of the present invention, the second glass plate 12 can also be replaced with a prefabricated part. In this case, it can be used to manufacture a laminated curved composite material combined of the first glass plate and the prefabricated part. The prefabricated part may be glass, ceramic or other material with similar thermal expansion coefficient to glass, or made of metal material, the prefabricated part can be prepared into a curved shape by tempering or other processes before being combined with the first glass plate 11, or the prefabricated part can be flat, for example, as shown in the following cases 6-8.

### Case 6: Panoramic roof glass

(1) Providing the first glass plate 11 and the second glass plate 12 with a thickness of 1.6 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 and the second glass plate 12 is 75MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 540s to a vacuum pressure of 30Pa, the first mold 21 is not heated, the second mold 22 is heated to 120°C, then the adhesive film 13 is melted, and then the first glass plate 11 and the second glass plate 12 are pressed respectively by the first mold 21 and the second mold 22 to a pressure of 90KPa, so that the first glass plate 11 is gradually attached to the concave surface of the first mold 21, and the second glass plate 12 is gradually attached to the convex surface of the second mold 22, and then maintain this state for 1200s, the laminated curved glass 10 is finally manufactured. During the pressing process, vacuuming is continued, and bubbles in the melted adhesive film 13 are gradually discharged, and finally the laminated curved glass 10 is obtained.
(4) Embed the glass products in the prefabricated frame of the panoramic roof glass and then fix it

### Case 7: Panoramic roof glass

(1) Providing the first glass plate 11 and the prefabricated part 12 with a thickness of 1.6 mm, the first glass plate 11 is flat sheet glass, in this case, the prefabricated part is double curved glass, and the sheet glass is float glass. The first glass plate 11 is cut to the desired size, and processed by edging, cleaning, etc.;
(2) The first glass plate 11 of step (1) is processed with strengthening treatment. After the treatment, the surface stress of the first glass plate 11 is 75MPa, and the flatness thereof is less than 3‰.
(3) Molding process, the first glass plate 11 strengthened in step (2), the adhesive film 13 and the prefabricated part are laminated in sequence and placed in a cold pressing device 20, moreover, the concave surface of the first mold 21 faces the first glass plate 11 and the convex surface of the second mold 22 faces the prefabricated part 12. When vacuuming for 540s to a vacuum pressure of 30Pa, the first mold 21 is not heated, the second mold 22 is heated to 120°C, then the adhesive film 13 is melted, and then the first glass plate 11 and the prefabricated part 12 are pressed respectively by the first mold 21 and the second mold 22 to a pressure of 90KPa, so that the first glass plate 11 is gradually attached to the concave surface of the first mold 21, and the prefabricated part 12 is gradually attached to the convex surface of the second mold 22, and maintain this state for 1200s, the laminated curved glass 10 is finally manufactured. During the pressing process, vacuuming is continued, and bubbles in the melted adhesive film 13 are gradually discharged, and finally the laminated curved glass 10 is obtained.
(4) The glass products are embedded and fixed in the prefabricated frame of the panoramic roof glass.

### Case 8: Solar photovoltaic bus roof

(1) Providing the first glass plate 11 and the bus roof prefabricated part 12 with a thickness of 1.6 mm, the first glass plate 11 is fiat solar photovoltaic embossed glass, the bus roof prefabricated part 12 is curved metal plate, and the material of the metal plate is preferably aluminum alloy, or other materials such as stainless steel. The first glass plate 11 is cut to the desired size, and processed by edging, cleaning, etc.;
(2) The first glass plate 11 of step (1) is processed with strengthening treatment. After the treatment, the surface stress of the first glass plate 11 is 75MPa, and the flatness is less than 3‰.
(3) Molding process, the first glass plate 11 strengthened in step (2), the adhesive film 13 and the bus roof prefabricated part 12 are laminated in sequence and placed in a cold pressing device 20, moreover, the concave surface of the first mold 21 faces the first glass plate 11 and the convex surface of the bus roof prefabricated part 12. The adhesive film 13 has a three-layer structure, which includes two layers of PVB and a string of photovoltaic cells sandwiched therebetween. When vacuuming for 300s to a vacuum pressure of 50Pa, the first mold 21 is not heated, the second mold 22 is heated to 100°C, then the adhesive film 13 is melted, and then the first glass plate 11 is pressed by the first mold 21 to a pressure of 80KPa, so that the first glass plate 11 is gradually attached to the concave surface of the first mold 21 and the convex surface of the prefabricated part 12, and maintain this state for 1000s, the laminated curved glass 10 is finally manufactured. During the pressing process, vacuuming is continued, and bubbles in the melted adhesive film 13 are gradually discharged, and finally the laminated curved glass 10 is obtained.
(4) In order to ensure the working lifespan of the photovoltaic system, the edge of the first glass plate 11 shall be fixed to the bus roof prefabricated part with metal strips.
(5) The power output of this photovoltaic bus roof is 200∼300W/m².

The above cases are embodiments of the present invention only, and should not be deemed as limitations to the scope of the present invention. It should be noted that relevant staff shall make various modifications or revises within the scope of the present invention. Therefore, the scope of the present application is defined by the appended claims.

## Claims

1. A composite material of laminated curved glass, wherein the composite material of laminated curved glass comprises a first glass plate, a prefabricated part, and an adhesive film configured between the first glass plate and the prefabricated part, the thickness of the first glass plate is 0.1 mm to 2.2 mm.

2. The composite material of laminated curved glass of claim 1, wherein the prefabricated part is made of at least one of glass, ceramics, and metal.

3. A manufacturing method of the composite material of laminated curved glass of claim 1 or clam 2, wherein the method comprises the following steps:
(1) providing the flat first glass plate with a thickness of 0.1 mm to 2.2 mm, and providing the flat prefabricated part;
(2) impose the first glass plate with strengthening treatment, the processed first glass plate is in the shape of a flat plate, and the surface stress of the first glass plate is 10-1000MPa; and
(3) low temperature molding process, adhesive film prepared, laminating the first glass plate processed in step (2), the adhesive film, and the prefabricated part in sequence, and then performing the low temperature press molding process to obtain the composite material of laminated curved glass.

4. The manufacturing method of the composite material of laminated curved glass of claim 3, wherein the prefabricated part is made of glass, and the prefabricated part is processed with the strengthening treatment of the step (2), the processed prefabricated part is in the shape of a flat plate, and the surface stress of the prefabricated part is 10- 1000MPa.

5. The manufacturing method of the composite material of laminated curved glass of claim 4, wherein after the first glass plate and the prefabricated part has been processed in the step (2), the surface stress of the first glass plate or the prefabricated part is 20-900 MPa, and the flatness of the first glass plate or the prefabricated part is less than 5‰*.*

6. The manufacturing method of the composite material of laminated curved glass of claim 3, wherein the step (3) is performed under vacuum conditions, the degree of vacuum ≤50Pa.

7. The manufacturing method of the composite material of laminated curved glass of claim 3, wherein the low temperature molding process is performed in a cold pressing device, the cold pressing device comprises a first mold for molding the first glass plate into a curved shape and a second mold for pressing the prefabricated part, the heating temperature of the first mold or the second mold is 80 °C to 380 °C.

8. The manufacturing method of the composite material of laminated curved glass of claim 7, wherein the first glass plate is pressed by the first mold so that the first glass plate is attached to the concave surface of the first mold, and the prefabricated part is pressed by the second mold so that the prefabricated part is attached to the convex surface of the second mold.

9. The manufacturing method of the composite material of laminated curved glass of claim 8, wherein the pressure applied by the first mold to the first glass plate or the second mold to the prefabricated part is 10-100 kPa.

10. The manufacturing method of the composite material of laminated curved glass of claim 3, wherein the prefabricated part is curved.
